Europäisches Patentamt

European Patent Office

Office européen des brevets

(11) Veröffentlichungsnummer: **0 309 875**
**A2**

# (12) EUROPÄISCHE PATENTANMELDUNG

(21) Anmeldenummer: 88115435.5

(22) Anmeldetag: 21.09.88

(51) Int. Cl.⁴: **H04N 9/64**

(30) Priorität: 30.09.87 DE 3733014

(43) Veröffentlichungstag der Anmeldung:
05.04.89 Patentblatt 89/14

(84) Benannte Vertragsstaaten:
**AT BE CH DE ES FR GB GR IT LI LU NL SE**

(71) Anmelder: **Deutsche Thomson-Brandt GmbH**
**Postfach 1307**
**D-7730 Villingen-Schwenningen(DE)**

(72) Erfinder: **Rufray, Jean Claude**
**Hans Thoma Strasse 6**
**D-7739 Brigachtal(DE)**
Erfinder: **Guillon, Jean Claude**
**10 Rue de Provence Gerstheim**
**F-67150 Erstein(FR)**

(74) Vertreter: **Körner, Peter, Dipl.-Ing.**
**Deutsche Thomson-Brandt GmbH Patent-**
**und Lizenzabteilung Göttinger Chaussee 76**
**D-3000 Hannover 91(DE)**

(54) **Demultiplexer.**

(57) Zur Erzielung einer Qualitätsverbesserung bei Fernsehbildern durch höhere Bildfrequenz bei gleichzeitig hoher Auflösung wird eine hohe Speicherkapazität benötigt.

Zur Verarbeitung eines zusammengesetzten Farbfernsehsignals wird ein Demultiplexer eingesetzt, der ein erstes Schieberegister besitzt, dem ein Datenstrom dieses Farbfernsehsignals zugeführt ist. Parallele Ausgänge dieses Schieberegisters sind mit einem Speicher verbunden. Außerdem ist ein zweites und drittes Schieberegister vorhanden, deren parallele Eingänge im Speicher verbunden sind und an deren seriellen Ausgängen die getrennten Komponenten des Farbfernsehsignals entnehmbar sind. Ferner ist eine Steuerschaltung aus Adresszählern vorgesehen, mittels welcher Zeilen und Spalten des ersten, zweiten und dritten Schieberegisters unabhängig voneinander ansteuerbar sind.

Die Erfindung vereinfacht den Speicheraufwand bei der digitalen Signalverarbeitung in Farbfernsehgeräten.

## Demultiplexer

Die Erfindung betrifft einen Demultiplexer nach dem Oberbegriff des Anspruchs 1.

Es ist bekannt, zur Vermeidung des Großflächenflimmerns bei Fernsehbildern die Bildfrequenz auf 100Hz statt wie bisher auf 50 Hz zu legen. Um die Kosten für Speichermittel in Grenzen zu halten, die erforderlich sind, um die digitalisierten Bild-Daten zwischenzuspeichern, wurde die Abtastrate für Luminanzkomponenten auf 10, 125 MHz und diejenige für Chrominanzkomponenten auf 3,375 MHz bei einem Zeilensprung-Abtastverfahren festgelegt.

Diese Frequenzen sind für natürliche Bilder groß genug, aber zu klein für hochauflösende Bilder, z.B. Computer-Graphiken. In letzterem Fall werden höhere Abtastfrequenzen bevorzugt, nämlich 13,5 MHz für Luminanz und 6,75 MHz für Chrominanz, wobei die Komponenten in jeder Zeile gewonnen werden. Dementsprechend wird also die Gesamtabtastrate noch einmal verdoppelt, im Vergleich zur flimmerfreien Abtastung im Zeilensprungverfahren.

Aus dem oben Erwähnten folgt, daß die Abtastrate für Luminanz 13,5 MHz, für den U-Anteil der Chrominanz 6,75 MHz und für den V-Anteil der Chrominanz ebenfalls 6,75 MHz. Die Gesamtabtastrate für Chrominanz beträgt also ebenfalls 13,5 MHz.

Übliche Bildspeicher sind nicht in der Lage, diesen Datenumfang zu speichern. Um trotzdem eine höhere Bildfrequenz zu erhalten, müßten die einzelnen Zeilen einmal wiederholt werden.

Der Nachteil einer solchen Schaltungsanordnung besteht darin, daß zusätzlich zu dem Bildspeicher Zeilenspeicher vorgesehen werden müssen. Die erfindungsgemäße Schaltungsanordnung kommt dagegen mit nur einem einzigen Speicher aus.

Ein Ausführungsbeispiel dieser Schaltung ist in der Zeichnung dargestellt.

Fig. 1 zeigt ein Blockschaltbild der erfindungsgemäßen Schaltung,

Fig. 2 zeigt die zeitliche Reihenfolge der an den seriellen Ein- und Ausgängen auftretenden Signale,

Fig. 3 zeigt die Speicherorganisation und

Fig. 4 zeigt anhand des Blochschaltbildes in Fig. 1 die Datenorganisation im Speicher.

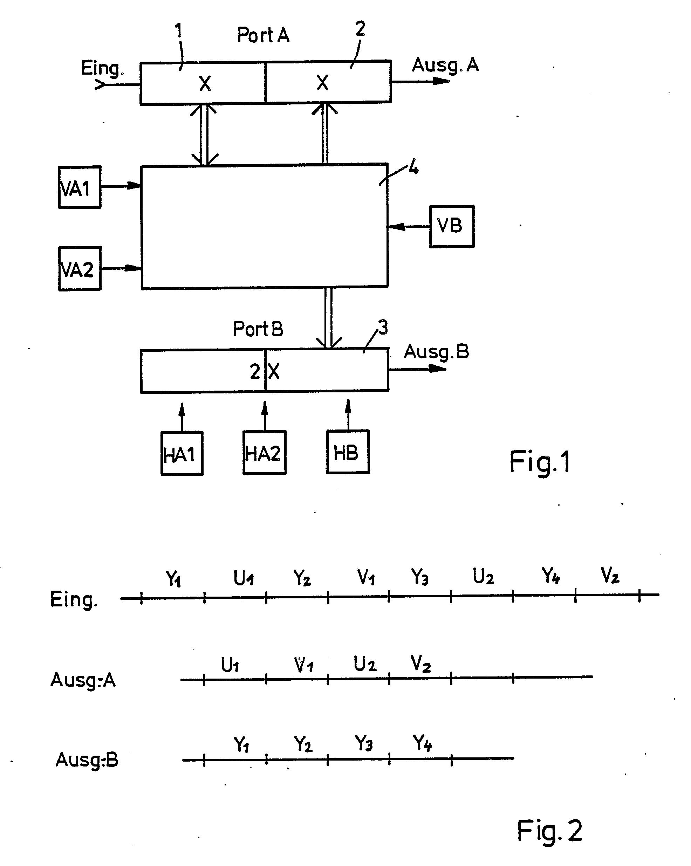

Fig. 1 zeigt ein Schieberegister 1 und ein Schieberegister 2, die zu einem Port A zusammengefaßt sind. Ferner ist ein Schieberegister 3 vorgesehen, das als Port B bezeichnet ist. Die Schieberegister sind über parallele Ein- oder Ausgänge mit einem Speicher 4 verbunden. Mittels Adresszähler VA1, VA2, VB für vertikal organisierte Speicherplätze und Adresszähler HA1, HA2 und HB für horizontal organisierte Speicherplätze können die Ein- und Ausgänge von Port A und Port B entsprechenden Speicherplätzen - unabhängig voneinander - zugewiesen werden. Die über den seriellen Eingang von Port A eintreffenden Daten können entsprechend der Zuweisung zu den Speicherplätzen aufgrund der Adresszähler VA1 und HA1 in Speicher 4 abgelegt werden. Zum Lesen der gespeicherten Informationen lassen sich entsprechende Speicherplätze mittels Adresszähler VA2 und HA2 dem Port A, sowie VB und HB dem Port B zuordnen. Bei dieser Zuordnung erfolgt nur ein Auslesen der gespeicherten Daten. Um ein Auslesen mit einer höheren Frequenz zu ermöglichen, sind die Schieberegister so organisiert, daß beim Einschreiben Blöcke der Blocklänge X vom Schieberegister in den Speicher übertragen werden und beim Auslesen Blöcke der Blocklänge 2X übertragen werden. Es ist dann möglich, die Schieberegister des Ports A mit der gleichen Taktfrequenz zu takten. Es ist auch möglich, beide Schieberegister für die Blocklänge 2X vorzusehen, aber beim Einschreiben der Daten nur Blöcke der Blocklänge X zu übertragen.

Mit dem so aufgebauten Demultiplexer lassen sich dann Datenströme aus 13,5 Millionen Abtastwerten pro Sekunde für Luminanz und zweimal 6,75 Millionen Abtastwerte pro Sekunde für Chrominanz einschreiben. Beim Auslesen läßt sich die doppelte Abtastrate erhalten.

Fig.2 zeigt die zeitliche Folge der Abtastwerte wie sie am seriellen Eingang des Schieberegisters auftritt. Die jeweils einer Zeile zugeordneten Abtastwerte sind mit dem Index 1, 2, 3, 4 usw. versehen. Die Abtastwerte werden in unterschiedlichen Speicherplätzen abgelegt und können bei der Ausgabe nach Luminanz- und Chrominanzanteilen getrennt über den Port A und den Port B ausgegeben werden. Der Vorteil der schon beim Einschreiben vorgenommenen Trennung zwischen den Luminanz- und Chrominanzanteilen besteht darin, daß beim Auslesen die entsprechenden Daten in der richtigen Zeit zur Verfügung gestellt werden können, sodaß zusätzliche Demultiplexer und Zwischenspeicher entfallen können. Zur Speicherung werden jeweils nur zwei Zeilen des Speichers benötigt. Die erste Zeile wird für die Luminanzanteile und die zweite Zeile für die Chrominanzanteile benutzt. Die eintreffenden Blöcke YN, CN, YN +1 usw. werden nacheinander auf dieselben Säulen der Reihen Y und C eingeschrieben. Diese Blöcke werden ausgewählt durch die Adresszähler HA1 und VA1 bzw. VA2. Zum Auslesen der Blöcke werden die C-Zeilen auf den Port A geschaltet, indem sie durch die Adresszähler HA2 und VA1 angesteuert werden und die Y-Zeilen auf den Port B geschaltet, der durch die Adresszähler HB und VB angesteuert wird. Diese Organisation ermöglicht es, statt acht Adresszählern nur sechs zu verwenden und so bei Integration von Zählern, Schieberegistern und Speichern auf einem Chip mit einer geringeren Chip-Fläche auszukommen.

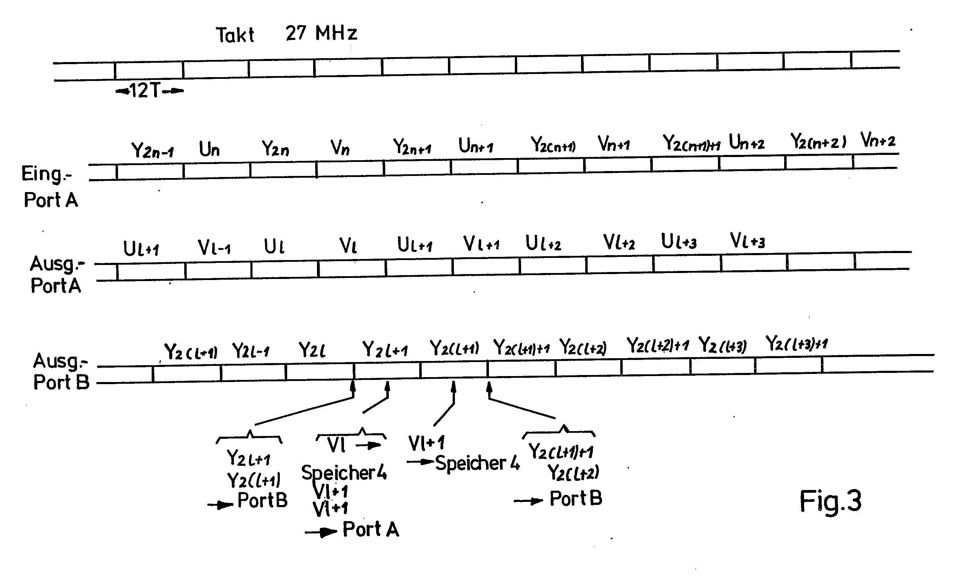

In **Fig. 3** ist der zeitliche Ablauf zwischen dem Einschreiben und dem Auslesen der Signale im Zusammenhang dargestellt.

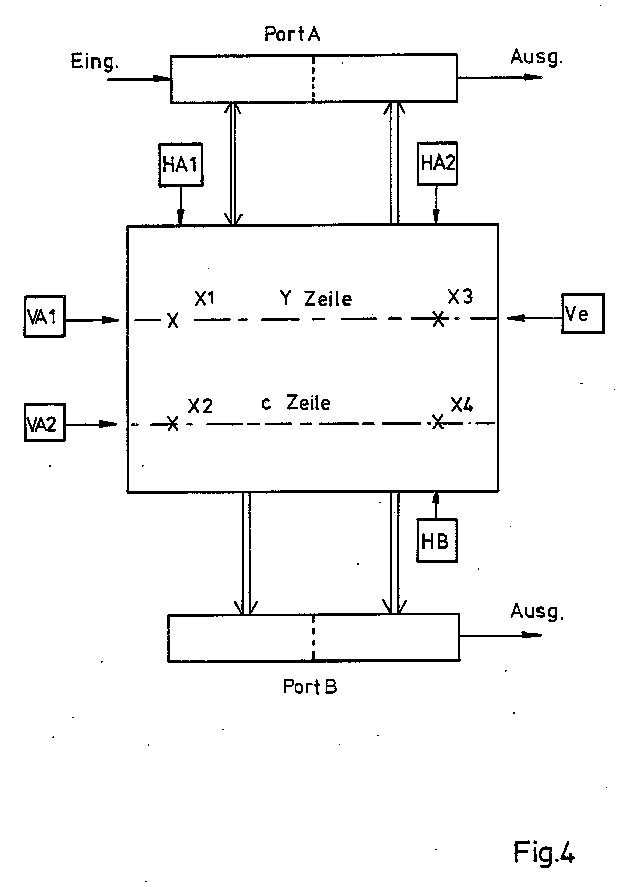

**Fig.4** zeigt noch einmal das aus Fig. 1 bekannte Blockschaltbild, in dem nun zwei Speicherzeilen dargestellt sind, in dessen einer die Luminanzanteile und in dessen anderer die Chrominanzanteile abgelegt werden. Einzelnen Speicherplätzen auf dieser Speicherzeile sind außerdem graphisch die Adresszähler zugeordnet, welche zur Auswahl der entsprechenden Speicherplätze angesteuert werden.

## Ansprüche

1. Demultiplexer für ein zusammengesetztes Farbfernsehsignal, **dadurch gekennzeichnet,** daß ein erstes Schieberegister (1) vorgesehen ist, dem ein Datenstrom des zusammengesetzten Farbfernsehsignals zugeführt ist, daß parallele Ausgänge des Schieberegisters (1) mit einem Speicher (4) verbunden sind, daß ein zweites (2) und drittes Schieberegister (3) vorgesehen ist, deren parallele Eingänge mit dem Speicher (4) verbunden sind und an deren seriellen Ausgängen die getrennten Komponenten des Farbfernsehsignals entnehmbar sind und daß eine Steuerschaltung aus Adresszählern (VA1, VA2, VB, HA1, HA2, HB)vorgesehen ist, mittels welcher Zeilen und Spalten des ersten (1), zweiten (2) und dritten (3) Schieberegisters unabhängig voneinander ansteuerbar sind.

Fig.1

Fig.2

EP 0 309 875 A2

Takt   27 MHz

◄12T►

Eing.-
Port A

$Y_{2n-1}$   $U_n$   $Y_{2n}$   $V_n$   $Y_{2n+1}$   $U_{n+1}$   $Y_{2(n+1)}$   $V_{n+1}$   $Y_{2(n+1)+1}$   $U_{n+2}$   $Y_{2(n+2)}$   $V_{n+2}$

Ausg.-
Port A

$U_{l+1}$   $V_{l-1}$   $U_l$   $V_l$   $U_{l+1}$   $V_{l+1}$   $U_{l+2}$   $V_{l+2}$   $U_{l+3}$   $V_{l+3}$

Ausg.-
Port B

$Y_{2(l-1)}$   $Y_{2l-1}$   $Y_{2l}$   $Y_{2l+1}$   $Y_{2(l+1)}$   $Y_{2(l+1)+1}$   $Y_{2(l+2)}$   $Y_{2(l+2)+1}$   $Y_{2(l+3)}$   $Y_{2(l+3)+1}$

$Y_{2l+1}$
$Y_{2(l+1)}$
→ PortB

$V_l$ →
Speicher4
$V_{l+1}$
$V_{l+1}$
→ Port A

$V_{l+1}$
→ Speicher 4

$Y_{2(l+1)+1}$
$Y_{2(l+2)}$
→ Port B

Fig.3

H87/057 –2

Fig.4

H87/057-3